Europäisches Patentamt

European Patent Office

Office européen des brevets

(19)

(11) Veröffentlichungsnummer: **0 125 630**
**A2**

# EUROPÄISCHE PATENTANMELDUNG

(12)

(21) Anmeldenummer: **84105277.2**

(22) Anmeldetag: **10.05.84**

(51) Int. Cl.³: **C 01 B 33/02**

(30) Priorität: **11.05.83 DE 3317286**

(43) Veröffentlichungstag der Anmeldung:
**21.11.84 Patentblatt 84/47**

(84) Benannte Vertragsstaaten:
**DE FR IT SE**

(71) Anmelder: **HELIOTRONIC Forschungs- und
Entwicklungsgesellschaft für Solarzellen-Grundstoffe
mbH
Johannes-Hess-Strasse 24
D-8263 Burghausen(DE)**

(72) Erfinder: **Bildl, Erich
Post Franking
A-5131 Holzöster Nr. 46(AT)**

(72) Erfinder: **Dietl, Josef, Dr. Dipl.-Phys.
Am Bärenbach 17
D-8265 Neuötting(DE)**

(72) Erfinder: **Baueregger, Rolf
Spitzsteinstrasse 19
D-8269 Burgkirchen(DE)**

(72) Erfinder: **Seifert, Dieter, Dr. Dipl.-Ing.
Siedlungsstrasse 12
D-8265 Neuötting(DE)**

(54) Verfahren zur Reinigung von Silicium durch Säureeinwirkung.

(57) Es wird ein Verfahren zur Säurereinigung von Silicium
angegeben, bei dem Silicium als stationäre Phase vorgelegt
und eine oder mehrere mobile saure Phasen durch Druckeinwirkung zum Durchströmen des Siliciums gebracht werden.

H E L I O T R O N I C

Forschungs- und Entwicklungsgesellschaft für Solarzellen-
Grundstoffe mbH

München, den 22.4.1983
PAT/Dr.K/we  **0125630**

Ht 8301
=======

Verfahren zur Reinigung von Silicium durch Säureeinwirkung

Die Erfindung betrifft ein Verfahren zur Reinigung von
Silicium durch Säureeinwirkung.

Eine kostengünstige Stromerzeugung mit Hilfe von Solarzellen
ist nur dann möglich, wenn es gelingt, das Grundmaterial
Silicium in ausreichend billiger Form bereitzustellen. Das
zur Herstellung von hochwertigem Silicium für elektronische
Zwecke gebräuchliche Verfahren scheidet dafür insbesondere
wegen der teuren Gasphasenreinigung aus. Da jedoch an die
Reinheit des sogenannten "Solarsiliciums" (auch als "solar
grade silicon" oder "terrestrial solar grade silicon" (TSG)
bezeichnet) keine derart hohen Anforderungen gestellt werden,
lassen sich zu dessen Herstellung billigere Reinigungsverfahren heranziehen, welche oft auch einen Reinigungsschritt
durch Säureeinwirkung beinhalten.

Bekannt ist aus der DE-AS 10 20 008, die Säure in großen
Bottichen unter tüchtigem Rühren auf das zu reinigende Silicium einwirken zu lassen. Gemäß der DE-AS 10 27 193 ist bekannt, Silicium durch sogenannte Haufenlaugung, also durch
intensives Anteigen mit verdünnter Salzsäure und nachfolgendes mehrtägiges Stehenlassen zu reinigen. Nach der CH-
PS 567 435 wird grobstückiges Silicium zur Reinigung von oben
in einen Reaktor mit nach oben gerichtetem Säurestrom eingetragen, sinkt nach unten und zerfällt unter Säurewirkung allmählich in kleine Teilchen, welche durch den Säurestrom nach oben
transportiert und aus dem Reaktor ausgetragen werden. Aus der
DE-OS 27 22 783 ist schließlich bekannt, Siliciumgranulat während der Säurebehandlung zusätzlich zu vermahlen. Die Nachteile dieser Verfahren liegen in dem Aufwand, den es erfordert,
die zu reinigenden Siliciumteilchen in ständiger Bewegung in
der Säurelösung zu halten, in der Gefahr von Verunreinigungen

- 2 -

0125630

durch Abrieb, oder aber, im Falle der Haufenlaugung, in
dem großen Zeitbedarf.

Aufgabe der Erfindung war es daher, ein Verfahren anzugeben, das gegenüber diesem Stand der Technik mit geringerem Aufwand und in kürzerer Zeit die wirksamere Reinigung von Silicium durch Säureeinwirkung gestattet.

Unerwartet wurde nun gefunden, daß sich als stationäre Phase
vorgelegtes Silicium unter Druckeinwirkung von mobilen sauren Phasen durchströmen läßt, ohne daß sich sogenannte
"Nester" ausbilden, also Bereiche, die mit der Säure nicht
ausreichend in Kontakt kommen und daher ungenügend gereinigt werden. Somit kann auf eine Bewegung der Siliciumpartikel in der Säure durch Rühren, Mahlen, Strömungstransport
und dergleichen oder auf ein intensives mechanisches Vermischen von Säure und Silicium, gefolgt von langwierigem
Stehenlassen, verzichtet werden.

Gelöst wird daher die Aufgabe durch ein Verfahren, welches
dadurch gekennzeichnet ist, daß das zu reinigende Silicium
als stationäre Phase vorgelegt wird, und daß eine oder
mehrere saure mobile Phasen durch Druckeinwirkung zum Durchströmen der stationären Phase gebracht werden.

Das erfindungsgemäße Verfahren eignet sich bevorzugt für
die Reinigung von Rohsilicium mit einem Siliciumgehalt von
über 95 Gew.-% (sogenanntes "metallurgical grade silicon")
oder auch von Reinsilicium, welches z.B. durch Umkristallisieren aus Metallschmelzen, etwa Aluminium, gewöhnlich in
Reinheiten von über 99 Gew.-% Si erhalten werden kann.
Grundsätzlich können jedoch auch stärker verunreinigte
Siliciumsorten, beispielsweise Legierungen, wie FeSi mit
60 bis 90 Gew.-% Siliciumanteil eingesetzt werden. Der
Einfachheit halber wird im folgenden für das geeignete Siliciumgrundmaterial der Ausdruck "Silicium" verwendet.

Als stationäre Phasen im Sinne der Erfindung sind allgemein Schichten von gegeneinander im wesentlichen unbeweglichen Siliciumteilchen zu verstehen. Solche Schichten lassen sich besonders günstig dadurch erzeugen, daß Siliciumteilchen aus Suspensionen oder Aufschlämmungen an Filterflächen, z.B. in Form eines Filterkuchens, abgeschieden werden. Dafür eignen sich insbesondere Filterpressen wie Kammer- oder Rahmenfilterpressen, aber auch andere Vorrichtungen, bei denen durch Druckeinwirkung eine flüssige Phase zum Durchströmen einer stationären festen Phase gebracht werden kann, also beispielsweise Druckfilternutschen, andere derartige Druckfilter oder auch entsprechend ausgerüstete Bandfilter.

Das Silicium kann in einem weiten Korngrößenbereich eingesetzt werden, wobei jedoch zu berücksichtigen ist, auf welche Art und Weise es als stationäre Phase vorgelegt werden soll. So wird man z.B. für Kammer- oder Rahmenfilterpressen, bei denen es in der Regel auf ein pumpfähiges Reaktionsgut ankommt, eher auf feinkörniges Material mit einer mittleren Korngröße von 0,1 bis 1000 μm, bevorzugt 1 bis 100 μm, zurückgreifen. Unter mittlerer Korngröße ist dabei zu verstehen, daß mindestens 50 % der Partikel eine Korngröße kleiner oder gleich dem angegebenen Wert besitzen. Hingegen kann z.B. bei Druckfilternutschen, bei denen das Reaktionsgut leichter einzubringen ist, auch grobkörnigeres Silicium mit Teilchengrößen bis über 10 mm eingesetzt werden. Bei letzterem wirkt sich die Tatsache günstig aus, daß infolge der Säureeinwirkung, welche hauptsächlich über die Korngrenzen vor sich geht, auch große Siliciumbrocken mit zunehmender Einwirkungsdauer allmählich in kleinere zerfallen.

Bekanntlich reichern sich in den Korngrenzen die Verunreinigungen an und können in der Regel nur dann entfernt werden, wenn diese auch freigelegt und damit der Säureeinwirkung zugänglich sind. Es empfiehlt sich daher allgemein, Siliciumpartikel mit einer mittleren Korngröße einzusetzen, die zumindest den Kristallitgrößen im kompakten Material entspricht. Wenn jedoch der Bereich der unangenehmen Feinstäube, also unterhalb einer Korngröße von etwa 1 µm, erreicht wird, ist es oft günstiger grobkörnigeres Material einzusetzen, da andernfalls die Schwierigkeiten bei der Handhabung den Vorteil der besseren Reinigungswirkung überwiegen.

Die gewünschte Korngrößenverteilung läßt sich durch Zermahlen des meist grobstückig vorliegenden Silicium erreichen. Zu diesem Zweck kommen die bekannten Feinzerkleinerungsmaschinen, also beispielsweise Trommel-, Schwing- oder auch Strahlmühlen in Frage. Das Silicium kann trocken oder naß zermahlen werden, wobei sich nasses Mahlgut gewöhnlich leichter handhaben läßt und somit beispielsweise nach dem Mahlvorgang leichter in eine Kammerfilterpresse einzubringen ist.

Als mobile saure Phase kommen die für die Säurereinigung von Silicium bekannten und beispielsweise in der eingangs zitierten Patentliteratur beschriebenen wäßrigen Säuren und Säuremischungen in Frage. Insbesondere sind als oxidierende Säuren Salpeter- und Schwefelsäure, als nicht oxidierende Säuren die Fluß- und die Salzsäure, die einzeln oder im Gemisch in den bekannten und üblichen Konzentrationen und Mischungsverhältnissen eingesetzt werden können, geeignet.

Zweckmäßig wird eine Temperatur von 10 bis 90 °C, vorzugsweise 20 bis 80 °C, eingehalten, wenn die saure Phase das als stationäre Phase vorliegende Silicium durchströmt. Diese Temperatur läßt sich jedoch grundsätzlich auch weiter steigern, wenn die verwendete Apparatur für die dann anfallenden und benötigten Drücke ausgelegt ist.

Erfahrungsgemäß läßt sich durch Temperaturerhöhung die erforderliche Einwirkungsdauer der Säuren oft beträchtlich verkürzen. So kann im allgemeinen bei einer Temperatur von 80 °C bereits nach 0,5 - 2 Stunden ein Reinigungseffekt erreicht werden, der dem nach 5 - 20 Stunden bei 20 °C vergleichbar ist.

Zur Durchführung des erfindungsgemäßen Verfahrens wird in
der Regel zunächst das zu reinigende Material mit Wasser
angeteigt, aufgeschlämmt oder suspendiert und dadurch pumpfähig gemacht. Dann wird die solcherart vorbereitete Masse
an ihren eigentlichen Einsatzort als stationäre Phase, also
z.B. in eine Kammerfilterpresse oder Druckfilternutsche überführt. Dafür eignen sich besonders gut Membranpumpen, da sie
einen einwandfreien, zuverlässigen Stofftransport gewährleisten. Mit ihrer Hilfe kann die Masse z.B. aus einem Vorratsbehältnis über geeignete Zuleitungen an den Einsatzort
gepumpt werden, wo der Festanteil an Filterflächen zurückgehalten wird und die gewünschte stationäre Phase ausbildet.

Die Dicke dieser zu durchströmenden Schicht wird günstig
in einem Bereich von 5 bis 50 mm, vorzugsweise 15 bis 35 mm,
gewählt. Bei geringeren Schichtdicken läßt sich meist nur
ein geringer und nicht mehr wirtschaftlicher Anlagendurchsatz erreichen. Bei größeren Schichtdicken hingegen ist wegen des starken Druckbedarfes der erforderliche apparative
Aufwand in der Regel nicht mehr vertretbar.

Die Oberflächen, die mit Silicium oder den Säuren in Kontakt
kommen, werden zweckmäßig aus Werkstoffen ausgewählt, welche
säurebeständig sind und keine Silicium dotierenden Fremdstoffe freisetzen können, also vorzugsweise aus Kunststoffen,
wie Polytetrafluorethylen, Polypropylen oder Polyvinylidenfluorid. Auch die Filtertücher, die z.B. in Kammerfilterpressen den Siliciumkuchen umhüllen und halten, werden vorzugsweise aus den genannten Materialien gefertigt, wobei
die Porengrößen günstig in der Größenordnung des zurückzuhaltenden Korns gewählt werden.

Nachdem das zu reinigende Silicium als stationäre Phase vorgelegt ist, kann mit der eigentlichen Säurebehandlung begonnen werden. Dabei wird man im allgemeinen nicht nur eine,
sondern mehrere verschiedene saure Phasen, die sich in ihrer
Reinigungswirkung ergänzen, nacheinander zum Durchströmen

0125630

bringen. Die Abfolge richtet sich nach den zu entfernenden Verunreinigungen; beispielsweise wird man calciumreiches Silicium erst mit Salzsäure und danach erst mit Flußsäure behandeln, um nicht schwer lösliches Calciumfluorid CaF$_2$ entstehen zu lassen. Geeignete Säuren, Säureabfolgen und Säuremischungen sind jedoch bekannt und z.B. in der eingangs erwähnten Patentliteratur beschrieben; sie bedürfen keiner weiteren Erläuterung.

Die jeweils gewählte mobile saure Phase wird durch Druckeinwirkung zum Durchströmen des zu reinigenden Siliciums gebracht. Im allgemeinen wird zu diesem Zweck die beispielsweise mittels Pumpen oder Kompressoren mit Druck beaufschlagte Flüssigkeit über geeignete Zuleitungen an die stationäre Phase herangeführt. An dieser bildet sich ein Druckgradient aus, der eine gleichmäßige Verteilung und einen stetigen Durchfluß der mobilen Phase bewirkt, welche sich dabei mit Verunreinigungen anreichert und diese entfernt. Die Säure kann auch durch den Druck eines Gases, beispielsweise Luft oder Inertgas, wie Stickstoff oder Argon, zum Durchfließen durch das zu reinigende Silicium gebracht werden. Gleichfalls möglich, zumeist aber aufwendiger, ist es, die mobile Phase durch die stationäre Phase zu saugen.

Die Druckbereiche, in denen gearbeitet werden kann, sind in der Regel durch die Druckstabilität der verwendeten Hilfsmittel, wie Pumpen, Zuleitungen, Filterpressen etc. vorgegeben und lassen sich in diesem Rahmen variieren. Bei Kammerfilterpressen oder Druckfilternutschen lassen sich beispielsweise im Druckbereich von 1 bis 16 bar gute Ergebnisse erzielen.

Günstig ist es auch, die jeweils vorliegende mobile Phase im Kreislauf ggf. längere Zeit durch die stationäre Phase strömen zu lassen.

Ein besonderer Vorteil des erfindungsgemäßen Verfahrens liegt darin, daß sich das als stationäre Phase vorliegende Silicium auf einfache Weise nicht nur nacheinander mit verschiedenen Säuren, sondern auch mit Gasen, vor allem Inertgas, oder mit Wasser beschicken läßt. Damit hat man die Möglichkeit, z.B. am Ende eines Säurebehandlungsschrittes die Säure, etwa mit Gas, auszupressen und das Silicium mit Wasser säurefrei zu waschen, bevor die nächste saure Phase eingesetzt wird. Man kann z.B. auch die ganze Apparatur durch Durchpressen von Inertgas, wie Stickstoff oder Argon, inertisieren, wenn bei der Säurebehandlung die Entwicklung von an Luft entzündlichen Gasen, wie manchen Silanen, zu erwarten ist. Günstig kann auch, nach abgeschlossener Reinigung das Silcium mit z.B. verdünnter NaOH oder wäßrigem Ammoniak durchströmt und einer Reaktionsbindung gemäß der deutschen Patentanmeldung mit Aktenzeichen 32 36 276.5 unterworfen werden. Schließlich läßt sich auch, durch Durchströmen erwärmter Gase, das vorgelegte Material trocknen.

Nach abgeschlossener Säurereinigung wird das ggf. säurefrei gewaschene und/oder reaktionsgebundene und/oder getrocknete Material entnommen und weiterverarbeitet, wobei sich meist zumindest ein weiterer, in der Regel pyrometallurgischer Reinigungsschritt, wie etwa Aufschmelzen in Verbindung mit Vakuumausdampfung oder Behandlung mit Extraktionsschmelzen anschließt. Für das Aufschmelzen ist insbesondere das reaktionsgebundene, stückige Material gut geeignet.

Das erfindungsgemäße Verfahren hat damit gegenüber der herkömmlichen Säurereinigung den Vorteil, daß eine Folge von Säure- und ggf. Nachbehandlungsschritten ohne mechanische Bewegung des Siliciums durchgeführt werden kann, wodurch z.B. die Gefahr von Verunreinigungen durch Abrieb, aber auch der Arbeitsaufwand gering zu halten ist. Dies gilt vor allem für den Einsatz der bevorzugten Filterpressen, insbesondere Kammerfilterpressen, die mit großem Fassungsvermögen zur Verfügung stehen, weitgehend automatisch betrieben werden können und, da sie keine bewegten Teile enthalten, leicht zu warten sind. Darüberhinaus sind derartige Filterpressen in gasdichter Ausführung erhältlich und damit völlig inertisierbar.

Anhand der folgenden Beispiele wird das erfindungsgemäße Verfahren weiter erläutert.

Beispiel 1

In Brockenform angeliefertes Rohsilicium wurde mittels Backenbrecher und Walzenstuhl vorzerkleinert und nach Klassierung mittels eines Taumelsiebs in einer Schwingmühle naß gemahlen. Das so erhaltene Pulver hatte eine mittlere Korngröße von 21 µm, der Feinanteil mit Korngröße unter 10 µm war 13 %, der Grobanteil mit Korngröße über 40 µm betrug 6 %. Das zusätzlich mit dem Mahlabrieb behaftete Material hatte die aus Tabelle 1 ersichtliche Reinheit.

60 kg dieses Siliciumpulvers wurden in Wasser aufgeschlämmt; die Suspension wurde mit Hilfe einer Membranpumpe in eine Kammerfilterpresse (Kammer- und Filterplattenmaterial Polyvinylidenfluorid) eingepumpt, bis die 12 Kammern (Abmessung jeweils 470 x 470 mm$^2$) bis zu einer Kuchenstärke von ca. 25 mm gefüllt waren.

Die eingesetzten wäßrigen mobilen Phasen waren mit einem Druck von 3 bar beaufschlagt und durchströmten die stationäre Phase mit einer Durchsatzrate von 5 m$^3$/h. Die angegebenen Flüssigkeitsmengen wurden jeweils im Kreislauf geführt, der Druck wurde mit Hilfe einer Membranpumpe erzeugt. Als Gas wurde Stickstoff mit einem Gasdruck von 2,5 bar eingesetzt. Die Säurebehandlung wurde bei Raumtemperatur durchgeführt und umfaßte die folgenden Schritte:

Zunächst wurden zur Vorreinigung 240 l HNO$_3$ (5 Gew.-%) während 1 Stunde durch die stationäre Siliciumphase gepumpt. Anschließend wurde die Säure mittels Stickstoff aus dem Silicium entfernt und dieses mit Wasser kurz säurefrei gewaschen. Darauf folgte eine zweite, vierstündige Vorreinigung mit 240 l HCl (20 Gew.-%) mit abschließendem Entfernen der Säure mit Stickstoff und kurzem Waschen mit Wasser.

Für die nachfolgende Hauptreinigung wurden 240 l eines 1 : 1-Gemisches aus HCl (15 Gew.-%) und HF (2 Gew.-%) 12 Stunden durch das Silicium gepumpt. Danach wurde die Säure wiederum mit Stickstoff ausgepresst und die verbliebenen Säurereste durch intensives Waschen mit Wasser entfernt. Dann wurde erneut Stickstoff durch das Silicium geleitet, bis es auf eine Restfeuchte von ca. 20 Gew.-% Wasseranteil vorgetrocknet war.

Dieses Produkt wurde sodann mit 0,1 Gew.-%-iger wäßriger Natronlauge angefeuchtet und zur Reaktionsbindung gebracht sowie abschließend zur Trocknung mit warmem Stickstoff (60 °C) durchströmt.

Das in Plattenform erhaltene Silicium enthielt noch die in Tabelle 1 zusammengestellten Verunreinigungen.

Tabelle 1

Reinigung von Rohsilicium
(angegebene Werte in Gew.-ppm.)

|  | Mn | Cr | Cu | Ni | Fe | Al | Ca | Mg | Ti |
|---|---|---|---|---|---|---|---|---|---|
| Rohsilicium mit Abrieb | 300 | 20 | 35 | 100 | 5600 | 3000 | 3000 | 100 | 250 |
| nach Säurebehandlung | < 2 | < 2 | < 2 | < 2 | 10 | 35 | 10 | < 2 | 1,5 |

Die erhaltenen Platten wurden anschließend in grobe Stücke zerbrochen und zur weiteren Reinigung aufgeschmolzen und einer Vakuumausdampfung unterzogen. Dieses Material konnte nach Vergießen zu Blöcken als Grundmaterial für Solarzellen verwendet werden.

Beispiel 2

Durch Umkristallisieren von Rohsilicium in Aluminium wurden Siliciumplättchen erhalten, die nach Abätzen des oberflächlich anhaftenden Aluminiums die aus Tabelle 2 ersichtliche Reinheit aufwiesen. Diese Plättchen wurden zur Vermeidung von Mahlabrieb in einer Luftstrahlmühle vermahlen und ergaben ein Pulver der mittleren Korngröße 15 μm (Feinanteil unter 5 μm 10 %, Grobanteil über 40 μm 5 %).

30 kg dieses Pulvers wurden in Wasser aufgeschlämmt und mittels einer Membranpumpe in eine Druckfilternutsche (Nutschenfläche 1 m²) gepumpt, wo sich ein Filterkuchen von ca. 30 mm Höhe ausbildete.

Bei einer Temperatur von 80 °C wurden die Flüssigkeiten im Kreislauf mittels einer Membranpumpe mit einem Druck von 10 bar und einer Durchflußrate von 2,5 m³/h durch den Filterkuchen gepresst. Auch der Druck des verwendeten Stickstoffs betrug 10 bar. Es wurden die folgenden Reinigungsschritte durchgeführt:

- Vorreinigung mit HCl (20 Gew.-%), wobei 100 l Flüssigkeit 1 Stunde lang zum Durchströmen gebracht wurden.

- Ausblasen der Säure mit Stickstoff und kurzes Waschen mit Wasser.

- Hauptreinigung mit einem 1 : 1-Gemisch von HCl (20 Gew.-%) und HF (5 Gew.-%), wobei 120 l Flüssigkeit während einer halben Stunde zum Durchströmen gebracht wurden.

- Ausblasen der Säure bis auf 20 % Restfeuchte und kurzes
  Waschen mit Wasser.

- Reaktionsbindung nach Anfeuchten mit 5 Gew.-%-igem wäßrigem Ammoniak.

Abschließend wurde das Produkt bei 80 °C mit Stickstoff getrocknet.

Das erhaltene Silicium wies die in Tabelle 2 angegebene
Reinheit auf.

Tabelle 2

Reinigung von umkristallisiertem Silicium
(angegebene Werte in Gew.-ppm.)

|  | Mn | Cr | Cu | Ni | Fe | Al | Ca | Mg | Ti |
|---|---|---|---|---|---|---|---|---|---|
| Si-Plättchen nach Umkristallisation | < 2 | < 2 | < 2 | < 2 | 6 | 1800 | 70 | 4 | 5 |
| Silicium nach Säurebehandlung | < 2 | < 2 | < 2 | < 2 | < 2 | 250 | < 2 | < 2 | < 1 |

Patentansprüche

1. Verfahren zur Reinigung von Silicium durch Säureeinwirkung, d a d u r c h   g e k e n n z e i c h -
   n e t , daß das zu reinigende Silicium als stationäre
   Phase vorgelegt wird, und daß eine oder eine Folge verschiedener mobiler saurer Phasen durch Druckeinwirkung
   zum Durchströmen der stationären Phase gebracht werden.

2. Verfahren nach Anspruch 1, d a d u r c h   g e -
   k e n n z e i c h n e t , daß die mobilen sauren Phasen aus der Gruppe der Säuren Salzsäure, Flußsäure,
   Salpetersäure, einzeln oder in Mischungen ausgewählt
   werden.

3. Verfahren nach Anspruch 1 oder 2, d a d u r c h
   g e k e n n z e i c h n e t , daß die mobilen sauren
   Phasen beim Durchströmen der stationären Phase im Kreislauf geführt werden.

4. Verfahren nach einem oder mehreren der Ansprüche 1 bis 3,
   d a d u r c h   g e k e n n z e i c h n e t , daß das
   zu reinigende Silicium in einer mittleren Korngröße von
   1 bis 100 µm eingesetzt wird.

5. Verfahren nach einem oder mehreren der Ansprüche 1 bis
   4, d a d u r c h   g e k e n n z e i c h n e t , daß
   das Durchströmen bei einer Temperatur von 20 bis 80 °C
   durchgeführt wird.

6. Verfahren nach einem der Ansprüche 1 bis 5, d a d u r c h
   g e k e n n z e i c h n e t , daß die stationäre Phase
   mit einer Schichtdicke von 5 bis 50 mm vorgelegt wird.

7. Verfahren nach einem oder mehreren der Ansprüche 1 bis 6, d a d u r c h   g e k e n n z e i c h n e t , daß im Anschluß an die Säurereinigung das Silicium einer Reaktionsbindung (gemäß der deutschen Patentanmeldung P 32 36 276.5) unterzogen wird, indem es zum In-Gang-Bringen einer sich selbst unterhaltenden Reaktionsbindung mit einem Silicium ätzenden Agens angefeuchtet wird und daß während und/oder nach der Reaktionsbindung verbleibende Flüssigkeitsanteile des Agens durch Temperatureinwirkung entfernt werden.